# EUROPÄISCHE PATENTSCHRIFT

(11) **EP 2 446 321 B1**
(45) Veröffentlichungstag und Bekanntmachung des Hinweises auf die Patenterteilung: **05.06.2013**
(21) Anmeldenummer: 10725675.2
(22) Anmeldetag: 15.06.2010
(51) Int. Cl.: G03B 21/20, H04N 9/31, H01L 33/50, G03B 21/14, G03B 33/08

(54) **Optisches Projektionsgerät mit zwei Lichtquellen**
Optical projection device with two light sources
Dispositif de projection optique avec deux sources de lumière

(30) Priorität: 25.06.2009 DE 102009030549
(43) Veröffentlichungstag der Anmeldung: 02.05.2012
(73) Patentinhaber: OSRAM Opto Semiconductors GmbH, 93055 Regensburg (DE)
(72) Erfinder: GRÖTSCH, Stefan, 93077 Lengfeld - Bad Abbach (DE); KOCUR, Simon, 81737 München (DE); SABATHIL, Matthias, 93059 Regensburg (DE)
(74) Vertreter: Epping - Hermann - Fischer
(86) Internationale Anmeldenummer: PCT/EP2010/058393
(87) Internationale Veröffentlichungsnummer: WO 2010/149539

(56) Entgegenhaltungen:
- JP-A- 2005 283 837
- US-A1- 2006 215 122
- US-A1- 2006 262 283
- US-A1- 2007 159 064
- US-A1- 2008 284 329

## Beschreibung

Es wird ein optisches Projektionsgerät nach dem Oberbegriff des Anspruchs 1 angegeben.

Ein solches Projektionsgerät ist z.B. aus der US 2006/0 262 283 A1 bekannt, weitere ähnliche Projektionsgeräte siehe z.B. JP 2005 283 837 A1 oder US 2006/0 215 122 A1.

Eine zu lösende Aufgabe besteht darin, ein optisches Projektionsgerät anzugeben, das eine erhöhte Effizienz aufweist.

Gemäß zumindest einer Ausführungsform des optoelektronischen Projektionsgeräts nach Anspruch 1 weist das optoelektronische Projektionsgerät eine erste Lichtquelle und eine zweite Lichtquelle auf. Das optische Projektionsgerät umfasst also zwei Lichtquellen. Bei dem optischen Projektionsgerät handelt es sich vorzugsweise um ein Zwei-Kanal-Projektionsgerät, das lediglich zwei Lichtquellen aufweist, deren Licht sich zu weißem Licht mischen kann.

Gemäß zumindest einer Ausführungsform des optischen Projektionsgeräts umfasst das optische Projektionsgerät ein bildgebendes Element. Bei dem bildgebenden Element kann es sich beispielsweise um ein LCD-Panel oder um ein Mikrospiegelarray handeln. Im Betrieb des optischen Projektionsgeräts wird das bildgebende Element von der ersten und der zweiten Lichtquelle ausgeleuchtet. Das bildgebende Element moduliert das Licht der ersten und zweiten Lichtquelle und erzeugt auf diese Weise ein Bild, das beispielsweise auf eine Projektionsfläche projiziert wird.

Gemäß zumindest einer Ausführungsform des optischen Projektionsgeräts umfasst die erste Lichtquelle einen im Betrieb rotes Licht emittierenden Leuchtdiodenchip. Die erste Lichtquelle kann dabei genau einen rotes Licht emittierenden Leuchtdiodenchip oder eine Vielzahl von Leuchtdiodenchips umfassen, die im Betrieb rotes Licht emittieren. Vorzugsweise umfasst die Lichtquelle keine Leuchtdiodenchips, die im Betrieb Licht einer anderen Farbe als rot emittieren.

Gemäß zumindest einer Ausführungsform des optischen Projektionsgeräts umfasst die zweite Lichtquelle einen ersten Leuchtdiodenchip und einen zweiten Leuchtdiodenchip. Der erste Leuchtdiodenchip emittiert im Betrieb grünes Licht und der zweite Leuchtdiodenchip emittiert im Betrieb blaues Licht. Der zweite Leuchtdiodenchip ist dabei an einer Strahlungsaustrittsfläche des ersten Leuchtdiodenchips auf dem ersten Leuchtdiodenchip angeordnet. Das heißt, der erste und der zweite Leuchtdiodenchip sind übereinander gestapelt angeordnet, wobei der blaues Licht emittierende Leuchtdiodenchip dem grünes Licht emittierenden Leuchtdiodenchip in dessen Abstrahlrichtung nachgeordnet ist. Das heißt, im Betrieb des ersten Leuchtdiodenchips erzeugte elektromagnetische Strahlung tritt durch den zweiten Leuchtdiodenchip. Der zweite Leuchtdiodenchip ist dazu strahlungsdurchlässig für die im ersten Leuchtdiodenchip erzeugte elektromagnetische Strahlung ausgebildet.

Aus der US 2007/0 159 064 A1 ist ein gestapelter leuchtdiodenchip bekannt, der rotes Licht aus einem darunter angeordneten blaues und grünes Licht emittierenden Chip erzeugt. Die US 2008/0 284 329 A1 offenbart ebenfalls einen Rotlicht erzeugenden Chip, der auf einem blaues Licht emittierenden Leuchtdiodenchip angeordnet ist.

Erster und zweiter Leuchtdiodenchip können monolithisch integriert hergestellt sein. Das heißt, erster und zweiter Leuchtdiodenchip können beispielsweise in einer einzigen Epitaxieanlage aufeinander folgend epitaktisch gewachsen sein. Alternativ ist es möglich, dass erster und zweiter Leuchtdiodenchip getrennt voneinander hergestellt sind und beispielsweise mittels eines Klebe-Prozesses miteinander verbunden sind.

Die zweite Lichtquelle kann dabei genau einen Stapel von ersten und zweiten Leuchtdiodenchips umfassen. Darüber hinaus ist es möglich, dass die zweite Lichtquelle eine Vielzahl solcher Stapel umfasst. In jedem Fall umfasst die zweite Lichtquelle vorzugsweise lediglich Stapel von ersten und zweiten Leuchtdiodenchips und zum Beispiel keine weiteren Leuchtdiodenchips, wie etwa rote Leuchtdiodenchips.

Gemäß zumindest einer Ausführungsform des optischen Projektionsgeräts umfasst das optische Projektionsgerät eine erste Lichtquelle, eine zweite Lichtquelle und ein bildgebendes Element, das im Betrieb von der ersten und der zweiten Lichtquelle ausgeleuchtet wird. Die erste Lichtquelle umfasst einen im Betrieb rotes Licht emittierenden Leuchtdiodenchip. Die zweite Lichtquelle umfasst einen ersten, im Betrieb grünes Licht und einen zweiten, im Betrieb blaues Licht emittierenden Leuchtdiodenchip, wobei der zweite Leuchtdiodenchip an einer Strahlungsaustrittsfläche des ersten Leuchtdiodenchips auf dem ersten Leuchtdiodenchip angeordnet ist, so dass im Betrieb im ersten Leuchtdiodenchip erzeugte elektromagnetische Strahlung durch den zweiten Leuchtdiodenchip tritt.

Bei dem hier beschriebenen optischen Projektionsgerät handelt es sich vorzugsweise um ein Zwei-Kanal-Projektionsgerät. Bei einem Zwei-Kanal-Projektionsgerät kann eine Grundfarbe - zum Beispiel Grün - durch eine einzelne Leuchtdioden-Lichtquelle erzeugt werden, während die beiden anderen Grundfarben - zum Beispiel Rot und Blau - von einem Leuchtdiodenmodul erzeugt werden, auf dem rote und blaue Leuchtdiodenchips nebeneinander angeordnet sind. Zur Überlagerung und Homogenisierung der beiden Farbkanäle (zum einen Grün und zum anderen Blau-Rot) können dichroitische Spiegel und optische Komponenten wie Mikrolinsenarrays (so genannte Fly-Eye-Arrays) oder stabförmige optische Integratoren (so genannte Integrator Rods) verwendet werden. Über ein Linsensystem kann das Licht dann sequenziell auf ein bildgebendes Element wie beispielsweise ein Digital Mirror Device (DMD) gelenkt und über eine Projektionsoptik vergrößert auf eine Leinwand projiziert werden.

Dem hier beschriebenen optischen Projektionsgerät liegt nun die folgende Überlegung zugrunde. Das Gesetz der Etendue-Erhaltung, wonach die Etendue proportional zu (sin α)^2 A ist, besagt, dass es für jedes Mikrodisplay in einem optischen Projektionsgerät (also zum Beispiel für jeden Mikrospiegel im bildgebenden Element des Projektionsgerät) eine maximal nutzbare Leuchtfläche der Leuchtdiodenchips der Lichtquellen des optischen Projektionsgeräts gibt. Die Etendue des Mikrodisplays wird dabei von seiner Fläche A und seinem Akzeptanzwinkel α bestimmt. Das Vergrößern der Leuchtdioden-Leuchtfläche hätte keinen positiven Effekt, da kein zusätzliches Licht in das optische System eingekoppelt werden kann.

Bei einem Zwei-Kanal Projektionssystem, bei dem sich die Farben Rot und Blau die maximal nutzbare Leuchtfläche teilen, während die Farbe Grün von einem einzelnen Leuchtdiodenmodul erzeugt wird, werden die blauen und roten Leuchtdiodenchips mit einer höheren Stromdichte betrieben, da ihnen nur die halbe Leuchtfläche des grünen Kanals des optischen Projektionsgeräts zur Verfügung steht. Der Wirkungsgrad einer Leuchtdiode sinkt jedoch vor allem bei blauen und grünen Leuchtdioden stark mit steigender Stromdichte, so dass die Gesamteffizienz des Zwei-Kanal-Projektionssystems darunter leidet. Der Vorteil eines hier beschriebenen Projektionssystems, mit einer zweiten Lichtquelle, die eine Stapelanordnung von einem grünen und einem blauen Leuchtdiodenchip in Kombination mit einer ersten Lichtquelle, die einen roten Leuchtdiodenchip aufweist, umfasst, liegt nun darin, dass für den grünes und für den blaues Licht emittierenden Leuchtdiodenchip die komplett nutzbare Leuchtfläche zur Verfügung steht. Die Stromdichten für die grünes und für die blaues Licht emittierenden Leuchtdiodenchips ist daher nicht größer zu wählen, als bei einem Drei-Kanal-Projektionsgerät, das für jede Grundfarbe ein eigenes, monochromes Leuchtdiodenmodul nutzt.

Gemäß zumindest einer Ausführungsform des optischen Projektionsgeräts ist die erste Lichtquelle dazu vorgesehen, rotes Licht zu emittieren und die zweite Lichtquelle ist dazu vorgesehen, grünes Licht, blaues Licht und/oder blau-grünes Licht zu emittieren. Das heißt im Betrieb des Projektionsgeräts emittieren die Lichtquellen zumindest zeitweise Licht der genannten Farben.

Gemäß zumindest einer Ausführungsform des optischen Projektionsgeräts weist die zweite Lichtquelle eine Spiegelschicht auf, die an einer dem zweiten Leuchtdiodenchip abgewandten Seite am ersten Leuchtdiodenchip befestigt ist. Bei der Spiegelschicht handelt es sich beispielsweise um einen dielektrischen und/oder einen metallischen Spiegel, der geeignet ist, sowohl das grüne Licht des ersten Leuchtdiodenchips als auch das blaue Licht des zweiten Leuchtdiodenchips zu reflektieren.

Gemäß zumindest einer Ausführungsform des optischen Projektionsgeräts umfasst das optische Projektionsgerät eine Steuervorrichtung, die geeignet ist, den ersten Leuchtdiodenchip der zweiten Lichtquelle im Betrieb des zweiten Leuchtdiodenchips der zweiten Lichtquelle kurzzuschließen. Das heißt, die Steuervorrichtung ist dazu vorgesehen, immer wenn der zweite Leuchtdiodenchip der zweiten Lichtquelle betrieben wird, den ersten Leuchtdiodenchip kurzzuschließen. Auf diese Weise können Ladungsträgerpaare, die im ersten Leuchtdiodenchip erzeugt werden, nicht strahlend rekombinieren. Der erste Leuchtdiodenchip kann dann nicht durch elektromagnetische Strahlung des zweiten Leuchtdiodenchips zur Reemission von Licht angeregt werden.

Gemäß zumindest einer Ausführungsform des optischen Projektionsgeräts wird ein Teil des im zweiten Leuchtdiodenchip der zweiten Lichtquelle im Betrieb erzeugten blauen Lichts im ersten Leuchtdiodenchip der zweiten Lichtquelle absorbiert und das absorbierte Licht regt dort die Erzeugung von grünem Licht an, derart, dass die zweite Lichtquelle im Betrieb des zweiten Leuchtdiodenchips Mischlicht aus blauen und grünem Licht emittiert. Das heißt, in diesem Fall wird die Anregung von grünem Licht im ersten Leuchtdiodenchip durch das blaue Licht des zweiten Leuchtdiodenchips nicht durch einen Kurzschluss des ersten Leuchtdiodenchips unterdrückt, sondern es wird zusätzlich grünes Licht erzeugt.

Gemäß zumindest einer Ausführungsform des optischen Projektionsgeräts weist die Steuervorrichtung zwei Betriebszustände auf. In einem ersten Betriebszustand ist der erste Leuchtdiodenchip der zweiten Lichtquelle im Betrieb des zweiten Leuchtdiodenchips der zweiten Lichtquelle kurzgeschlossen, so dass die zweite Lichtquelle im Betrieb des zweiten Leuchtdiodenchips farbreines, blaues Licht emittiert. Im zweiten Betriebszustand ist der erste Leuchtdiodenchip im Betrieb der zweiten Leuchtdiode der zweiten Lichtquelle nicht kurzgeschlossen, so dass die zweite Lichtquelle im Betrieb des zweiten Leuchtdiodenchips Mischlicht aus blauem und grünem Licht emittiert.

Das heißt, mittels der Steuervorrichtung kann gewählt werden, ob die zweite Lichtquelle farbreines blaues Licht emittiert oder ob die zweite Lichtquelle blau-grünes Mischlicht emittiert.

Im ersten Betriebszustand ist das Projektionsgerät geeignet, Bilder in einem besonders großen Farbraum darzustellen. Im zweiten Betriebszustand ist der Farbraum eingeschränkt, da kein reines blaues Licht erzeugt wird. Andererseits ist jedoch die Effizienz der zweiten Lichtquelle erhöht, da ein Teil des blauen Streulichts genutzt wird, um grünes Licht zu erzeugen.

Gemäß zumindest einer Ausführungsform des optischen Projektionsgeräts ist an einer Strahlungsaustrittsfläche des Leuchtdiodenchips der ersten Lichtquelle eine Linse optisch angeschlossen. Optisch angeschlossen heißt dabei, dass die Linse dem Leuchtdiodenchip ohne Luftspalt nachgeordnet ist. Beispielsweise kann die Linse direkt auf die Strahlungsaustrittsfläche des Leuchtdiodenchips aufgesetzt sein. Ferner ist es möglich, dass die Linse über beispielsweise ein Index Matching Gel oder einen optischen Klebstoff am Leuchtdiodenchip angeschlossen ist. Die Linse hat zwar den Nachteil, dass die nutzbare Leuchtfläche des Leuchtdiodenchips reduziert wird, jedoch wird die Auskoppeleffizienz des roten Lichts aus dem Leuchtdiodenchip um bis zu 70 % gesteigert, so dass die Effizienz des optischen Projektionsgeräts weiter erhöht ist.

Gemäß zumindest einer Ausführungsform des optischen Projektionsgeräts ist im Lichtpfad zwischen der ersten Lichtquelle und dem bildgebenden Element und im Lichtpfad zwischen der zweiten Lichtquelle und dem bildgebenden Element ein dichroitischer Spiegel angeordnet, der geeignet ist, das Licht der ersten Lichtquelle und das Licht der zweiten Lichtquelle auf das bildgebende Element zu lenken. Der dichroitische Spiegel kann dabei wesentlich unkomplizierter aufgebaut sein, als dies bei einem Zwei-Kanal-Projektionsgerät der Fall ist, bei dem blaue und rote Leuchtdiodenchips zu einem gemeinsamen Leuchtdiodenmodul angeordnet sind. Dies ist unter anderem darin begründet, dass der Wellenlängenunterschied zwischen grünem und blauem Licht wesentlich geringer als zwischen rotem und blauem Licht ist. Aufgrund des einfacheren dichroitischen Spiegels weist das optische Projektionsgerät verringerte fresnelsche Filterverluste und damit eine erhöhte Effizienz auf.

Gemäß zumindest einer Ausführungsform des optischen Projektionsgeräts ist im Lichtpfad zwischen der ersten Lichtquelle und dem bildgebenden Element und im Lichtpfad zwischen der zweiten Lichtquelle und dem bildgebenden Element jeweils kein optisches Element angeordnet. Das heißt, die Lichtpfade sind frei von optischen Elementen. Mit anderen Worten leuchten die erste und die zweite Lichtquelle das bildgebende Element direkt aus. In diesem Fall wird vollständig beispielsweise auf einen dichroitischen Spiegel verzichtet. Durch eine leichte Defokussierung der beiden Lichtquellen kann auch ohne weitere optische Komponenten eine ausreichende Homogenität der Ausleuchtung des bildgebenden Elements erreicht werden. Die Mischung der drei Grundfarben erfolgt dann direkt am bildgebenden Element, was eine sehr kompakte Bauform des optischen Projektionsgeräts unter Vermeidung von fresnelschen Verlusten erlaubt. Das optische Projektionsgerät zeichnet sich daher durch eine besonders hohe Effizienz aus.

Im Folgenden wird das hier beschriebene optische Projektionsgerät anhand von Ausführungsbeispielen und den zugehörigen Figuren näher erläutert.
- Die Figuren 1A und 1B: zeigen anhand schematischer Schnittdarstellungen Ausführungsformen einer zweiten Lichtquelle für ein hier beschriebenes optisches Projektionsgerät.
- Die Figur 1C: zeigt anhand einer schematischen Schaltskizze die Verschaltung der zweiten Lichtquelle eines hier beschriebenen optischen Projektionsgeräts.
- Die Figuren 2A, 2B und 2C: dienen zur Erläuterung von Eigenschaften eines hier beschriebenen optischen Projektionsgeräts anhand graphischer Auftragungen.
- Die Figur 3: zeigt eine graphische Auftragung, anhand derer Eigenschaften des hier beschriebenen optischen Projektionsgeräts näher erläutert sind.
- Die Figuren 4A und 4B: zeigen Ausführungsbeispiele hier beschriebener optischer Projektionsgeräte in schematischen Schnittdarstellungen.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

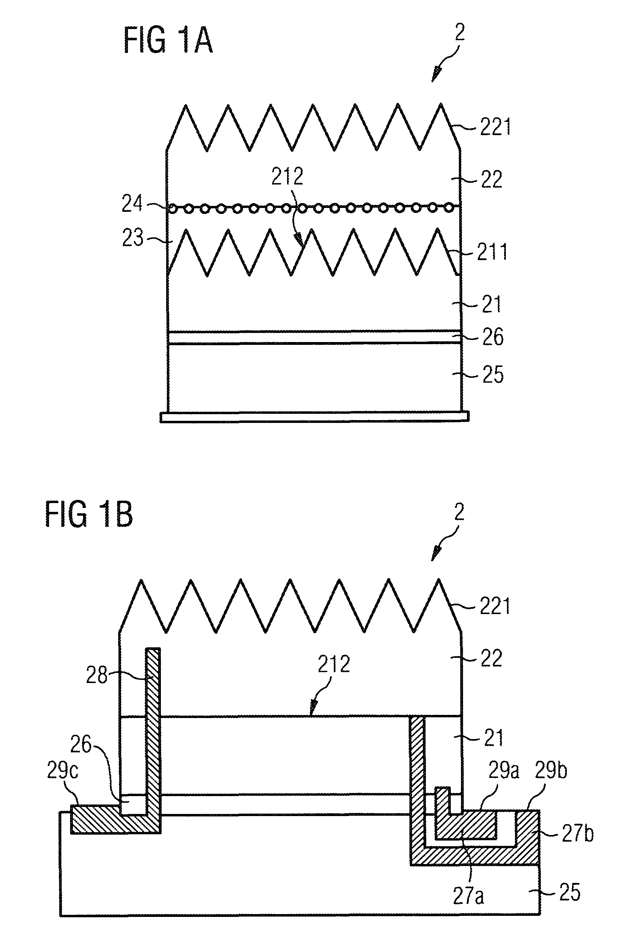

Die Figur 1A zeigt eine erste Ausführungsform einer zweiten Lichtquelle 2 für ein hier beschriebenes optisches Projektionsgerät. Die zweite Lichtquelle 2 umfasst einen ersten Leuchtdiodenchip 21 und einen zweiten Leuchtdiodenchip 22. Ferner umfasst die zweite Lichtquelle 2 einen Träger 25. Zwischen dem Träger 25 und dem ersten Leuchtdiodenchip 21 ist eine Spiegelschicht 26 angeordnet. Erster Leuchtdiodenchip 21 und zweiter Leuchtdiodenchip 22 sind über ein Verbindungsmittel 23 miteinander verbunden. An der dem ersten Leuchtdiodenchip 21 zugewandten Seite des zweiten Leuchtdiodenchips 22 befindet sich eine Kontaktschicht 24, die strahlungsdurchlässig ausgestaltet ist.

Beim ersten Leuchtdiodenchip 21 handelt es sich um einen grünes Licht emittierenden Leuchtdiodenchip, der ebenfalls auf dem InGaN-Halbleitermaterialsystem basiert.

Bei dem zweiten Leuchtdiodenchip 22 handelt es sich um einen für grünes Licht strahlungsdurchlässigen, substratlosen blauen Leuchtdiodenchip, der beispielsweise auf dem InGaN-Halbleitermaterialsystem basiert.

Bei der Spiegelschicht 26 handelt es sich beispielsweise um einen Silberspiegel, der dazu geeignet ist, sowohl grünes als auch blaues Licht zu reflektieren. Der Träger 25 ist beispielsweise aus Germanium gebildet.

Das Verbindungsmittel 23 ist strahlungsdurchlässig ausgebildet und beispielsweise aus Silikon und/oder Epoxidharz gebildet. Die strahlungsdurchlässige Kontaktschicht 24 ist beispielsweise aus einem TCO (Transparent Conductive Oxide) gebildet, wie etwa ITO (Indium Tin Oxide) oder IZO (Indium Zinc Oxide).

Der erste Leuchtdiodenchip 21 kann Auskoppelstrukturen 211 aufweisen, die beispielsweise durch Aufrauungen der dem ersten Leuchtdiodenchip 22 zugewandten Strahlungsaustrittsfläche 212 des ersten Leuchtdiodenchips 21 gebildet sind.

In gleicher Weise kann auch der zweite Leuchtdiodenchip 22 Auskoppelstrukturen 221 aufweisen. Auch die Auskoppelstrukturen 221 des zweiten Leuchtdiodenchips 22 können durch Aufrauungen gebildet sein. Die Auskoppelstrukturen 211, 221 erhöhen jeweils die Wahrscheinlichkeit für einen Strahlungsdurchtritt durch die Strahlungsaustrittsflächen der Leuchtdiodenchips.

Im Betrieb der zweiten Lichtquelle 2 emittiert der zweite Leuchtdiodenchip 22 beispielsweise blaues Licht. Ein Teil des blauen Lichts kann dabei in den ersten Leuchtdiodenchip 21 gelangen. Das blaue Licht wird im ersten Leuchtdiodenchip 21 teilweise absorbiert und ein Teil des absorbierten Lichts wird im ersten Leuchtdiodenchip 21 zu grünem Licht konvertiert. Ein anderer Teil des blauen Lichts, das in den ersten Leuchtdiodenchip 21 gelangt ist, wird an der Spiegelschicht 26 zum zweiten Leuchtdiodenchip 22 hin reflektiert und tritt als blaues Licht aus der zweiten Lichtquelle 2 aus. Das durch das blaue Licht angeregte grüne Licht (ungefähr 30 % des gesamten Lichtstroms der zweiten Lichtquelle) kann zur Lichterzeugung genutzt werden, wodurch die zweite Lichtquelle 2 blau-grünes Mischlicht emittiert. Dies senkt zwar die Größe des Farbraums des optischen Projektionsgeräts ab, erhöht jedoch dessen Effizienz.

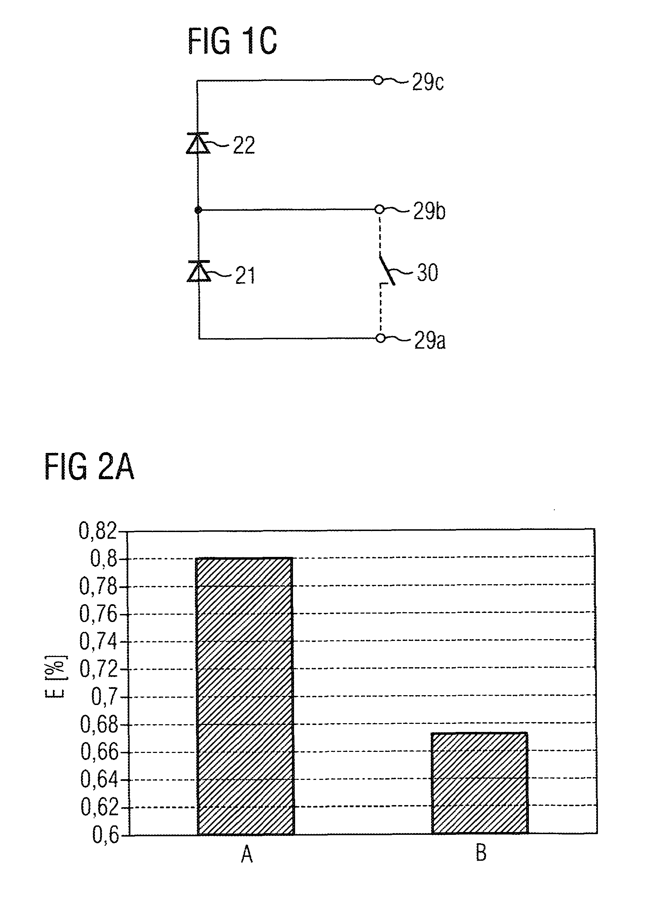

Alternativ kann die Anregung von grünem Licht durch einen Kurzschluss des ersten Leuchtdiodenchips 21 im Betrieb des zweiten Leuchtdiodenchips 22 unterdrückt werden. Eine Schaltung hierfür ist beispielsweise in der Figur 1C näher dargestellt. Die zweite Lichtquelle 2 umfasst dazu eine Steuervorrichtung 30, die durch einen Schalter realisiert ist. Durch die Steuervorrichtung 30 können die Kontaktstellen 29A, 29B des ersten Leuchtdiodenchips 21 kurzgeschlossen werden, so dass im Betrieb des zweiten Leuchtdiodenchips 22 im ersten Leuchtdiodenchip 21 keine elektromagnetische Strahlung erzeugt werden kann.

Die Steuervorrichtung 30 weist also einen ersten Betriebszustand auf, in dem der erste Leuchtdiodenchip 21 der zweiten Lichtquelle 2 im Betrieb des zweiten Leuchtdiodenchips 22 der zweiten Lichtquelle 2 kurzgeschlossen ist, derart, dass die zweite Lichtquelle 2 im Betrieb des zweiten Leuchtdiodenchips 22 blaues Licht emittiert, und einen zweiten Betriebszustand, in dem die zweite Lichtquelle 2 im Betrieb des zweiten Leuchtdiodenchips 22 Mischlicht aus blauem'und grünem Licht emittiert.

Die Figur 1B zeigt anhand einer schematischen Schnittdarstellung eine zweite Ausführungsform einer zweiten Lichtquelle 2, wie sie in einem hier beschriebenen optischen Projektionsgerät zum Einsatz kommen kann. In dieser Ausführungsform sind der erste Leuchtdiodenchip 21 und der zweite Leuchtdiodenchip 22 monolithisch integriert aufgebaut. Das heißt, sie sind epitaktisch aufeinander abgeschieden, so dass kein Verbindungsmittel 23 zur Verbindung von erstem Leuchtdiodenchip 21 und zweitem Leuchtdiodenchip 22 notwendig ist. Eine Kontaktierung der Leuchtdiodenchips erfolgt dabei mittels Kanälen 27a, 27b, 28, die mit einem elektrisch leitenden Material gefüllt sind und in die Kontaktschichten der Leuchtdiodenchips 21, 22 reichen. Eine Kontaktierung der Leuchtdiodenchips 21, 22 erfolgt über die Anschlussstellen 29a, 29b, 29c.

Gegenüber der in Verbindung mit der Figur 1A beschriebenen Lichtquelle zeichnet sich die in der Figur 1B beschriebene Lichtquelle durch eine erhöhte Effizienz aus. Dies ist insbesondere darin begründet, dass keine Absorption von elektromagnetischer Strahlung im Verbindungsmittel 23 oder in der Kontaktschicht 24 erfolgen kann. Andererseits ist die Herstellung der zweiten Lichtquelle, wie sie in der Figur 1B gezeigt ist, aufgrund der komplizierten Fototechnik, die zur Herstellung der Kanäle 27a, 27b, 28 notwendig ist, aufwändiger.

Die Figur 2A zeigt die Auskoppeleffizienz E für zweite Lichtquellen 2, wie sie in der Figur 1A gezeigt sind. Der Balken A zeigt dabei die Effizienz für eine zweite Lichtquelle 2 mit einer Kontaktschicht 24 mit einer Dicke von 100 nm, die aus IZO gebildet ist. Der Balken B zeigt die Effizienz für eine zweite Lichtquelle 2 mit einer Kontaktschicht 24, die 250 nm dick ist und aus IZO gebildet ist. Die Auskoppeleffizienz für den Balken A beträgt dabei ungefähr 80 %, für den Balken B ungefähr 67 %. Das heißt, aufgrund der Kontaktschicht 24 sind optische Verluste von wenigstens 20 % zu erwarten.

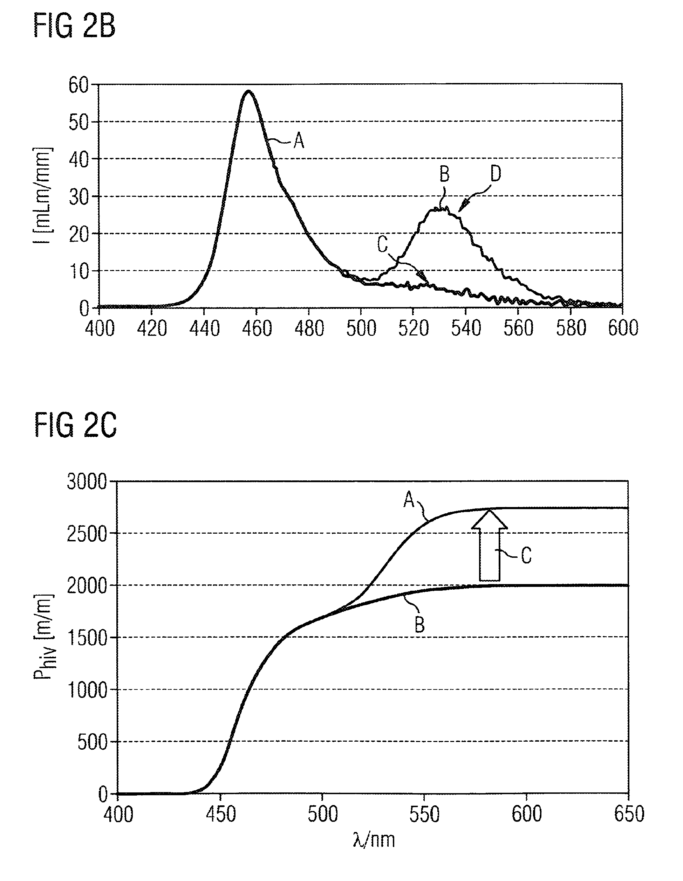

Die Figur 2B zeigt die Intensität in mlm/nm aufgetragen über die Wellenlänge für eine zweite Lichtquelle 2, bei der die Erzeugung von grünem Licht durch Kurzschließen des ersten Leuchtdiodenchips 21 verhindert ist, siehe Kurve A. Ferner ist die Intensität einer zweiten Lichtquelle 2 gezeigt, bei der die Erzeugung von grünem Licht nicht verhindert ist, wenn der zweite Leuchtdiodenchip 22 betrieben wird, siehe Kurve B. Die Erhebung in der Intensität beim Punkt D ist dabei auf die Anregung von grünen Photonen durch die blauen Photonen aus dem zweiten Leuchtdiodenchip 22 zurückzuführen. Durch ein Kurzschließen des ersten Leuchtdiodenchips 21 kann die Erzeugung von grünem Licht unterdrückt werden, siehe Bereich C.

Die Figur 2C zeigt den kumulierten Lichtstrom PhiV in mlm in Abhängigkeit von der Wellenlänge für eine zweite Lichtquelle 2, bei der die Erzeugung von grünem Licht im ersten Leuchtdiodenchip 21 beim Betrieb des zweiten Leuchtdiodenchips 22 unterbunden ist, siehe Kurve B. Ferner ist in Kurve A der kumulierte Lichtstrom dargestellt, für den Fall, dass die Erzeugung von grünem Licht nicht unterbunden ist. Wie aus der Figur 2C ersichtlich ist, kann das grüne Licht des ersten Leuchtdiodenchips 21 zur Erhöhung der Effizienz um ungefähr 30 % des gesamten Lichtstroms genutzt werden (siehe auch Pfeil C). Bei Unterdrückung der Erzeugung des grünen Lichts ergibt sich hingegen ein größerer Farbraum.

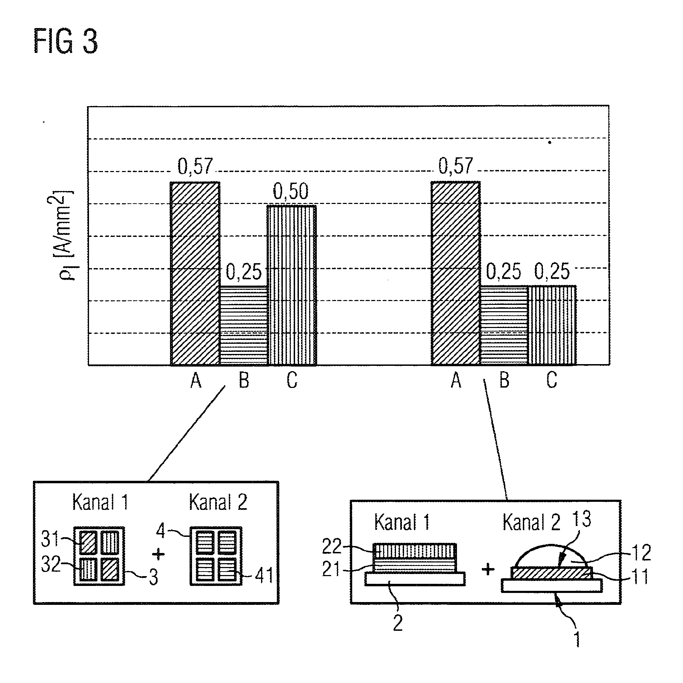

Die Figur 3 zeigt die Stromdichte pI in Ampere pro Quadratmillimeter für zwei unterschiedliche Zwei-Kanal-Projektionsgeräte. Bei dem optischen Projektionsgerät handelt es sich dabei um ein 16 : 9-Projektionsgerät mit einem 0,3"-Mikrodisplay und einer Gesamtleistung von 1 W. Die Balken A zeigen dabei die Stromdichte der roten Leuchtdiodenchips, die Balken B die Stromdichte der grünen Leuchtdiodenchips und die Balken C die Stromdichte der blauen Leuchtdiodenchips.

Die Balken auf der linken Seite zeigen die Stromdichte für die Situation, wie sie im darunter dargestellten Kasten gezeigt ist. Das optische Projektionsgerät umfasst dabei eine erste Lichtquelle 3, die rote Leuchtdiodenchips 31 und blaue Leuchtdiodenchips 32 umfasst. Ferner umfasst das optische Projektionsgerät eine zweite Lichtquelle 4, die lediglich grüne Leuchtdiodenchips 41 umfasst.

Die rechten Balken betreffen ein optisches Projektionsgerät mit gestapelten grünen Leuchtdiodenchips 21 und blauen Leuchtdiodenchips 22 in der zweiten Lichtquelle 2 und einem roten Leuchtdiodenchip 11 in der ersten Lichtquelle 1, dem eine Linse 12 an seiner Strahlungsauskoppelfläche 13 direkt nachgeordnet ist.

Wie aus der Auftragung der Figur 3 ersichtlich ist, beträgt im rechts dargestellten Fall die Stromdichte des blauen Chips 50 % von der links dargestellten Situation. Dadurch ergibt sich eine erhöhte Effizienz des optischen Projektionsgeräts.

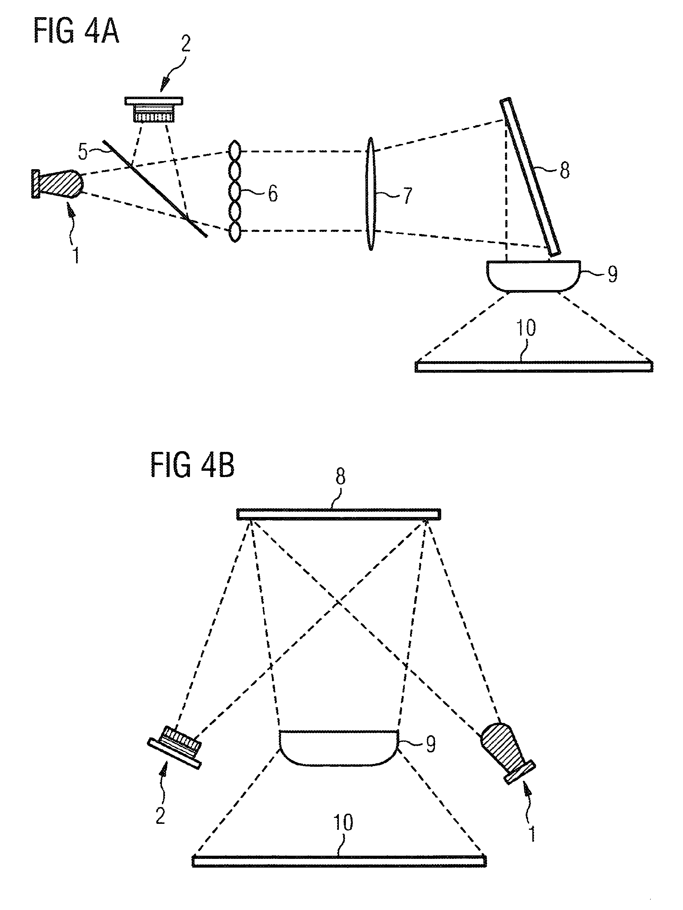

Die Figur 4A zeigt ein hier beschriebenes optisches Projektionsgerät in einer schematischen Schnittdarstellung gemäß einer ersten Ausführungsform. Das optische Projektionsgerät umfasst eine erste Lichtquelle 1, wie sie beispielsweise in der Figur 3 gezeigt ist. Ferner umfasst das optische Projektionsgerät eine zweite Lichtquelle 2, wie sie beispielsweise in Verbindung mit den Figuren 1A und 1B näher beschrieben ist. Das optische Projektionsgerät umfasst ferner einen dichroitischen Spiegel 5, der die Lichtstrahlen der ersten Lichtquelle 1 und der zweiten Lichtquelle 2 in einem einzigen Lichtpfad vereinigt. Das optische Projektionsgerät umfasst ferner optische Elemente 6, 7 bei denen es sich beispielsweise um ein Mikrolinsenarray 6 und eine stabförmige Mischoptik 7 handeln kann. Das Licht der ersten und der zweiten Lichtquelle wird abwechselnd auf das bildgebende Element 8 gelenkt, bei dem es sich beispielsweise um ein Mikrospiegelarray handelt. Von einer Projektionsoptik 9 wird das durch das bildgebende Element 8 modulierte Licht auf die Projektionsfläche 10 gelenkt.

In Verbindung mit der Figur 4B ist ein optisches Projektionsgerät gezeigt, bei dem auf optische Elemente zwischen den Lichtquellen 1, 2 und dem bildgebenden Element 8 verzichtet ist. Die Homogenisierung des Lichts der Lichtquellen 1, 2 erfolgt dabei durch leichte Defokussierung beider Lichtquellen, so dass die Lichtmischung direkt am bildgebenden Element 8 erfolgen kann.

Insgesamt ergibt sich durch die Verringerung der Stromdichte für die blauen Leuchtdiodenchips sowie die Verwendung einer Auskoppellinse 12 für die roten Leuchtdiodenchips insgesamt eine Erhöhung der Effizienz des optischen Projektionsgeräts um zirka 30 % gegenüber einem optischen Projektionsgerät, das ein Leuchtdiodenmodul mit blauen und roten Leuchtdiodenchips sowie ein Leuchtdiodenmodul mit grünen Leuchtdiodenchips umfasst.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Beispielsweise erstreckt sich der Schutzbereich der Ansprüche auch auf optische Projektionsgeräte, bei denen andere Leuchtdiodenchips zum Einsatz kommen, als rotes Licht, grünes Licht und blaues Licht emittierende Leuchtdiodenchips. Wichtig ist lediglich, dass sich das erzeugte Licht der Leuchtdiodenchips zu weißem Licht mischen kann. In der ersten Lichtquelle kommt dann zumindest ein Leuchtdiodenchip eines ersten Wellenlängenbereichs zum Einsatz.

In der zweiten Lichtquelle kommen zumindest ein Leuchtdiodenchip eines zweiten Wellenlängenbereichs als erster Leuchtdiodenchip und zumindest ein Leuchtdiodenchip eines dritten Wellenlängenbereichs als zweiter Leuchtdiodenchip zum Einsatz. Der erste Wellenlängenbereich umfasst dabei elektromagnetische Strahlung der längsten Wellenlängen, der zweite Wellenlängenbereich elektromagnetische Strahlung mittlerer Wellenlängen und der dritte Wellenlängenbereich elektromagnetische Strahlung der kürzesten Wellenlängen.

## Patentansprüche

1. Optisches Projektionsgerät mit
- einer ersten Lichtquelle (1),
- einer zweiten Lichtquelle (2), und
- einem bildgebenden Element (8), das im Betrieb von der ersten (1) und der zweiten Lichtquelle (2) ausgeleuchtet wird, wobei
- die erste Lichtquelle (1) einen im Betrieb rotes Licht emittierenden Leuchtdiodenchip (11) umfasst,
- die zweite Lichtquelle (2) einen ersten (21), im Betrieb grünes Licht und einen zweiten (22), im Betrieb blaues Licht emittierenden Leuchtdiodenchip umfasst, und
- die erste Lichtquelle (1) dazu vorgesehen ist, rotes Licht zu emittieren und die zweite Lichtquelle (2) dazu vorgesehen ist, grünes Licht, blaues Licht und/oder Mischlicht aus blauem und grünem Licht zu emittieren, **dadurch gekennzeichnet, dass** der zweite Leuchtdiodenchip (22) an einer Strahlungsaustrittsfläche (212) des ersten Leuchtdiodenchips (21) auf dem ersten Leuchtdiodenchip (21) angeordnet ist, so dass im Betrieb im ersten Leuchtdiodenchip (21) erzeugte elektomagnetische Strahlung durch den zweiten Leuchtdiodenchip (22) tritt.

2. Optisches Projektionsgerät gemäß dem vorherigen Anspruch, bei dem die zweite Lichtquelle (2) eine Spiegelschicht (26) aufweist, die an einer dem zweiten Leuchtdiodenchip (22) abgewandten Seite am ersten Leuchtdiodenchip (21) befestigt ist.

3. Optisches Projektionsgerät gemäß einem der vorherigen Ansprüche, mit einer Steuervorrichtung (30), die geeignet ist, den ersten Leuchtdiodenchip (21) der zweiten Lichtquelle (2) im Betrieb des zweiten Leuchtdiodenchips (22) der zweiten Lichtquelle (2) kurzzuschließen.

4. Optisches Projektionsgerät gemäß einem der vorherigen Ansprüche,
bei dem ein Teil des im zweiten Leuchtdiodenchip (22) der zweiten Lichtquelle (2) im Betrieb erzeugten blauen Lichts im ersten Leuchtdiodenchip (21) der zweiten Lichtquelle (2) absorbiert wird und dort die Erzeugung von grünem Licht anregt, derart, dass die zweite Lichtquelle (2) im Betrieb des zweiten Leuchtdiodenchips (22) Mischlicht aus blauem und grünem Licht emittiert.

5. Optisches Projektionsgerät gemäß einem der beiden vorherigen Ansprüche,
bei dem die Steuervorrichtung (30)
- einen ersten Betriebszustand aufweist, in dem der erste Leuchtdiodenchip (21) der zweiten Lichtquelle (2) im Betrieb des zweiten Leuchtdiodenchips (22) der zweiten Lichtquelle (2) kurzgeschlossen ist, derart, dass die zweite Lichtquelle (2) im Betrieb des zweiten Leuchtdiodenchips (22) blaues Licht emittiert, und
- einen zweiten Betriebszustand aufweist, in dem die zweite Lichtquelle (2) im Betrieb des zweiten Leuchtdiodenchips (22) Mischlicht aus blauem und grünem Licht emittiert.

6. Optisches Projektionsgerät gemäß einem der vorherigen Ansprüche,
bei dem an eine Strahlungsaustrittsfläche (13) des Leuchtdiodenchips (11) der ersten Lichtquelle (1) eine Linse (12) optisch angeschlossen ist.

7. Optisches Projektionsgerät gemäß einem der vorherigen Ansprüche,
bei dem im Lichtpfad zwischen der ersten Lichtquelle (1) und dem bildgebenden Element (8) und im Lichtpfad zwischen der zweiten Lichtquelle (2) und dem bildgebenden Element (8) ein dichroitischer Spiegel (5) angeordnet ist.

8. Optisches Projektionsgerät gemäß einem der Ansprüche 1 bis 6,
bei dem der Lichtpfad zwischen der ersten Lichtquelle (1) und bildgebenden Element (8) und der Lichtpfad zwischen der zweiten Lichtquelle (2) und bildgebenden Element (8) jeweils frei von optischen Elementen sind.

9. Optisches Projektionsgerät gemäß einem der Ansprüche 1 bis 6,
bei dem die erste (1) und die zweite (2) Lichtquelle das bildgebende Element (8) direkt ausleuchten.

## Claims

1. Optical projection apparatus comprising
- a first light source (1),
- a second light source (2), and
- an imaging element (8), which is illuminated by the first (1) and the second light source (2) during operation,
wherein
- the first light source (1) comprises a light-emitting diode chip (11), that emits red light during operation,
- the second light source (2) comprises a first light-emitting diode chip (21), which emits green light during operation, and a second light-emitting diode chip (22), which emits blue light during operation, and
- the first light source (1) is provided for emitting red light and the second light source (2) is provided for emitting green light, blue light and/or mixed light composed of blue and green light, **characterized in that** the second light-emitting diode chip (22) is arranged on the first light-emitting diode chip (21) at a radiation exit area (212) of the first light-emitting diode chip (21), such that electromagnetic radiation generated in the first light-emitting diode chip (21) during operation passes through the second light-emitting diode chip (22).

2. Optical projection apparatus according to the preceding claim,
wherein the second light source (2) has a mirror layer (26), which is fixed to the first light-emitting diode chip (21) at a side remote from the second light-emitting diode chip (22).

3. Optical projection apparatus according to either of the preceding claims,
comprising a control device (30) suitable for short-circuiting the first light-emitting diode chip (21) of the second light source (2) during the operation of the second light-emitting diode chip (22) of the second light source (2).

4. Optical projection apparatus according to any of the preceding claims,
wherein part of the blue light generated in the second light-emitting diode chip (22) of the second light source (2) during operation is absorbed in the first light-emitting diode chip (21) of the second light source (2) and excites the generation of green light there in such a way that the second light source (2) emits mixed light composed of blue and green light during the operation of the second light-emitting diode chip (22).

5. Optical projection apparatus according to either of the two preceding claims,
wherein the control device (30)
- has a first operating state, in which the first light-emitting diode chip (21) of the second light source (2) is short-circuited during the operation of the second light-emitting diode chip (22) of the second light source (2) in such a way that the second light source (2) emits blue light during the operation of the second light-emitting diode chip (22), and
- has a second operating state, in which the second light source (2) emits mixed light composed of blue and green light during the operation of the second light-emitting diode chip (22).

6. Optical projection apparatus according to any of the preceding claims,
wherein a lens (12) is optically connected to a radiation exit area (13) of the light-emitting diode chip (11) of the first light source (1).

7. Optical projection apparatus according to any of the preceding claims,
wherein a dichroic mirror (5) is arranged in the light path between the first light source (1) and the imaging element (8) and in the light path between the second light source (2) and the imaging element (8).

8. Optical projection apparatus according to any of Claims 1 to 6,
wherein the light path between the first light source (1) and imaging element (8) and the light path between the second light source (2) and imaging element (8) are in each case free of optical elements.

9. Optical projection apparatus according to any of Claims 1 to 6,
wherein the first (1) and the second (2) light source directly illuminate the imaging element (8).

## Revendications

1. Appareils de projection optique comportant
- une première source de lumière (1),
- une seconde source de lumière (2), et
- un élément de formation d'image (8) qui est éclairé lors du fonctionnement par les première (1) et seconde (2) sources de lumière, dans lequel
- la première source de lumière (1) comprend une puce de diode électroluminescente émettant de la lumière rouge lors du fonctionnement (11),
- la seconde source de lumière (2) comprend une diode électroluminescente émettant une première (21) lumière verte lors du fonctionnement et une seconde (22) lumière bleue lors du fonctionnement, et
- la première source de lumière (1) est conçue pour émettre de la lumière rouge et la seconde source de lumière (2) est conçue pour émettre de la lumière verte, de la lumière bleue et/ou une lumière mélangée constituée de lumières bleue et verte, **caractérisé en ce que** la seconde puce de diode électroluminescente (22) est disposée sur une surface de sortie de rayonnement (212) de la première puce de diode électroluminescente (21) sur la première puce de diode électroluminescente (21) de manière à ce que lors du fonctionnement, un rayonnement électromagnétique généré dans la première puce de diode électroluminescente (21) pénètre à travers la seconde puce de diode électroluminescente (22).

2. Appareil de projection optique selon la revendication précédente, dans lequel la seconde source de lumière (2) comprend une couche formant miroir (26) qui est fixée à une face opposée à la seconde puce de diode électroluminescente (22) sur la première puce de diode électroluminescente (21).

3. Appareil de projection optique selon l'une quelconque des revendications précédentes, comportant un dispositif de commande (30) qui est conçu pour court-circuiter la première puce de diode électroluminescente (21) de la seconde source de lumière (2) pendant le fonctionnement de la seconde puce de diode électroluminescente (22) de la seconde source de lumière (2).

4. Appareil de projection optique selon l'une quelconque des revendications précédentes, dans lequel une partie de la lumière bleue générée lors du fonctionnement dans la seconde puce de diode électroluminescente (22) de la seconde source de lumière (2) est absorbée dans la première puce de diode électroluminescente (21) de la seconde source de lumière (2) et y stimule la génération de lumière verte de telle manière que la seconde source de lumière (2) émette lors du fonctionnement de la seconde puce de diode électroluminescente (22) une lumière mélangée constituée de lumières bleue et verte.

5. Appareil de projection optique selon l'une quelconque des deux revendications précédentes, dans lequel le dispositif de commande (30)
- présente un premier état de fonctionnement dans lequel la première puce de diode électroluminescente (21) de la seconde source de lumière (2) est court-circuitée lors du fonctionnement de la seconde puce de diode électroluminescente (22) de la seconde source de lumière (2) de telle manière que la seconde source de lumière (2) émette de la lumière bleue lors du fonctionnement de la seconde puce de diode électroluminescente (22), et
- présente un second état de fonctionnement dans lequel la seconde source de lumière (2) émet une lumière mélangée constituée de lumières bleue et verte lors du fonctionnement de la seconde puce de diode électroluminescente (22).

6. Appareil de projection optique selon l'une quelconque des revendications précédentes,
dans lequel une lentille (12) est liée optiquement à une surface de sortie de rayonnement (13) de la puce de diode électroluminescente (11) de la première source de lumière (1).

7. Appareil de projection optique selon l'une quelconque des revendications précédentes, dans lequel un miroir dichroïque (5) est disposé sur le chemin optique entre la première source de lumière (1) et l'élément de formation d'image (8) et sur le chemin optique entre la seconde source de lumière (2) et l'élément de formation d'image (8).

8. Appareil de projection optique selon l'une quelconque des revendications 1 à 6, dans lequel le chemin optique entre la première source de lumière (1) et l'élément de formation d'image (8) et le chemin optique entre la seconde source de lumière (2) et l'élément de formation d'image (8) sont respectivement exempts d'éléments optiques.

9. Appareil de projection optique selon l'une quelconque des revendications 1 à 6, dans lequel les première (1) et seconde (2) sources de lumière éclairent directement l'élément de formation d'image (8).
